# EUROPEAN PATENT APPLICATION

(11) **EP 2 533 282 A2**
(43) Date of publication of application: **12.12.2012**
(21) Application number: 12170798.8
(22) Date of filing: 05.06.2012
(51) Int. Cl.: H01L 23/367

(54) **Modular heat sink**

(30) Priority: 07.06.2011 IT PI20110062
(71) Applicant: Broccio, Giuseppe, 98048 Spadafora (ME) (IT); Serraino, Carmelo, 98057 Milazzo (ME) (IT); Broccio, Concetta, 98048 Spafadora (ME) (IT); Calapristi, Nunziata, 98048 Spadafora (ME) (IT)
(72) Inventor: Broccio, Giuseppe, 98048 Spadafora (ME) (IT); Serraino, Carmelo, 98057 Milazzo (ME) (IT); Broccio, Concetta, 98048 Spafadora (ME) (IT)
(74) Representative: Turini, Laura

(57) **Abstract**

The present invention concerns a heat sink **(1)** for semiconductor light emitters or for light absorbers and comprising:
- A central portion **(2)** provided with attachment means **(7, 8, 9)** on which it is possible to fix the light emitter or the absorber and;
- a plurality of tabs **(3)** that branches off from the central body and distanced between them so as to form a plurality of channels for the circulation of air.

In accordance with the invention, the tabs **(3)** are arranged substantially parallel between them and at a reciprocal distance comprised within a range variable between 9 mm and 11 mm, in such a way as to optimize the passage of air for cooling.

The heat sink (1) has an external overall shape in general parallelepiped-shaped, which favours the modular composition of two or more modular sinks (1) and the scalability with the least encumbrance.

## Description

### Technical field

The present invention concerns the technical field relative to heat sinks.

In particular, the invention refers to an innovative heat sink for semiconductor light emitters such as LED and LASER LED diodes, or for concentrated light solar cells, Seebeck effect cells or thermal micromotors.

### Background art

The semiconductor light emitters, such as the LED diodes commonly called just LED, have been known for some time. The functioning of the LED is based on the phenomenon called "electro-luminescence", due to the emission of photons in the band of the visible and products from the re-combination of the electrons and the electron holes when the junction is polarized in direct sense.

Differently from the common light bulbs, in which the filament works at very high temperatures and is characterized by significant thermal inertia, the LED, like the LASER LED, emit cool light and can blink at very high frequencies, superior to the MHz. If we consider that the light emitted is directly proportional to the current that goes through them, the LED and the LASER LED result particularly suitable for the transmission of signals through various types of modulation of the luminous intensity.

On of the many uses of the LED and the LASER LED is, for example, that of injectors of signals in the connections to optical fibres. The LED are also capable of emitting very high luminous intensities with reduced consumption and guarantee a much longer duration with respect to the normal filament bulbs.

Nevertheless, it is known that the average life of a LED depends strongly on its temperature of use, which must be necessarily maintained within an optimal range of 70°C - 80°C in the junction, allowing to reach an average life of about 80.000 hours, beyond which the decay of the performances becomes significant.

It is therefore essential to be able to maintain the temperature within said limits so as not to reduce the average useful life of the LED below a commercially convenient value.

For the power LED, in the current state, there are not present sinks capable of answering well to these needs without the help of further forced ventilation systems that render the device itself more complex structurally speaking, and also noisy.

The same problem is found in the case of devices different from said LED, such as the Laser LED, concentrated photovoltaic cells, Seebeck effect devices or thermal micromotors.

It is known how an important parameter of optimization is the parallel arrangement of the cooling tabs and therefore the parallelepiped conformation of the device on the whole that allows the realization of tabs parallel between them and appropriately distanced. This allows to optimize the number of tabs and their reciprocal distance.

For example, in US2010259927 a sink for LED of the modular type is described. It comprises a superior surface, on which the LED are arranged, and an inferior surface, from which the tabs branch off radially ortoghonally to the surface itself. This system is not anyway efficient because, even if it is parallelepiped-shaped and with tabs parallel between them, the distance between the tabs is not such as to favour a convective motion of the air responsible for the main cooling. Moreover, the arrangement of the tabs arranged on the surface opposite to that to which the LED are applied does not allow an efficient cooling when the tabs are, for example, closet o a roof or one opposed to the other one in the case of modularity with two opposed pieces of furniture. Last, this structure does not render the passage of wires easy.

In US2009/0323338 a complex cylindrical system is instead described, in which spheral dome-shaped reflecting elements are included inside which the Led are arranged. The dome shape of the reflecting elements is such that a high light reflecting effect is generated. Nevertheless, this system, due precisely to its cylindrical form, is incompatible with the requirements for the optimization of the dissipation that requires a parallelepiped form and the arrangement of tabs parallel between them. Moreover, although in the cited document a distance between the tabs of about 10mm to optimize the convective dissipation effect is discussed, this distance cannot be maintained constant in a cylindrical form. It is in fact clear that the tabs, which branch off radially from the surface from which they emerge ortoghonally, increase progressively their reciprocal distance from the attachment root, going towards their cusp.

### Disclosure of invention

It is therefore the aim of the present invention to provide a thermal sink that solves at least in part said technical inconveniences.

In particular, it is the aim of the present invention to provide a thermal sink that allows to make the light absorbing or emitting device work within an optimal range of temperatures without the help of fans of other auxiliary cooling systems.

It is therefore the aim of the present invention to provide a sink that results efficient and, at the same time, structurally simple and of minimum encumbrance.

These and other aims are therefore obtained with the present thermal sink 1 in accordance with claim 1.

The sink, according to the invention, comprising a central portion **(2)** provided with attachment means **(7, 8, 9)** on which the light emitter or the absorber can be fixed. From the central portion **(2)** a plurality of tabs **(3)** branch off distanced between them in such a way as to form a plurality of channels for the circulation of the air and such so that the overall form of the sink is parallelepiped.

According to the invention, in order to optimize the performances of heat dissipation, the tabs **(3)** are arranged parallel between them and at a distance comprised within a range variable between 9 mm and 11 mm in such a way as to optimize the passage of the air for cooling.

Such a spacing optimizes the thermal dispersion since it reduces also the effect of mutual radiation between the tabs and, at the same time, allows to optimize the number of tabs.

In this way, it is not necessary any auxiliary cooling device, the whole rendering such a thermal sink particularly efficient and structurally simple.

Further advantages can be deduced from the dependent claims.

### Brief description of drawings

Further characteristics and advantages of the present thermal sink, according to the invention, will result clearer with the description of some preferred embodiments that follows, made to illustrate but not to limit, with reference to the annexed drawings, wherein:
- Figure 1 shows a top view of the heat sink according to the invention;
- Figure 2 shows a front view from the part of the wall 4;
- Figures from 3 to 5 show possible modular combinations between the sinks;
- Figure 6 shows a solution with a cap-like cover for the LED;
- Figure 7 shows other modular solutions of sinks 1 provided with cap;
- Figure 8 shows four modules connected centrally to a feeder through external electrical wires;
- Figure 9 and figure 10 show two further variants of the invention.

### Description of some preferred embodiments

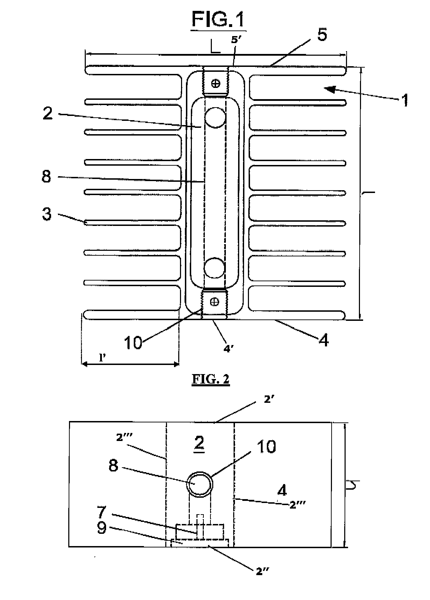

Figure 1 shows, in a top view, a thermal sink 1 for semiconductor devices, such as the LED, concentrated light solar cells or Seebeck effect cells or thermal micromotors.

The device 1 is generally parallelepiped-shaped and comprises a central portion 2 from which a plurality of tabs 3 branch off. Figure 2 shows a frontal view of the sink from the part of the front wall 4, which is exactly the same as the back wall 5, in such a way as to form a parallelepiped-shaped three-dimensional body. Figure 2 in a dotted line highlights the part that constitutes the central body 2.

The central body, as per figure 2, includes a superior surface 2', an inferior surface 2", two lateral surfaces 2"' and, naturally, the front surface 4' and the back surface 5'. The form is therefore parallelepiped as well.

As better clarified below, the inferior surface is provided with the attachment of the LED.

Starting from the two lateral surfaces 2"', a plurality of cooling tabs 3 extend radially parallel between them and distanced in such a way as to form convective channels for the passage of the cooling air.

The tabs, as always shown in figure 1, have a predetermined thickness "s" and a height h coinciding with the height h of the sink. The tabs are therefore emerging orthogonally from the two lateral surfaces 2"' in such a way as to result perpendicular to the plane 2' and 2".

In this way, the overall form of the sink is parallelepiped. Moreover, in accordance with such a solution and unlike US2010259927, for example, when the sink is connected closet o the rook with the light emitters directed downwards, the heat dissipation is not invalidated since the air flow circulates freely between the tabs, something that is instead not realizable in a solution in which the tabs are developed radially starting from the surface opposite to the surface of application of the LED.

The two faces, front 4 and back 5, are also flat and lacking tabs. As better clarified below, this allows an easy passage 8 of the wires, an easy modularity and an easy connection to external supports, such as a wall.

In the present description forms are used that in plant result both rectangular (see figure 1, for example) and also square.

The sink 1 is preferably realized in aluminium or in aluminium-based alloys.

The aluminium is wiredrawn and then custom-cut, according to a perpendicular or oblique plane to the wiredrawing axis, in the desired final form.

The aluminium is in fact a material that, in addition to having an optimal thermal conductivity, has good mechanical resistance and lightness properties. Moreover, it is a material of long consumption that is easily worked.

Said parallelepiped form is essential and advantageous because it guarantees the realization of the greater number of tabs 3 parallel between them. As better explained below, the parallel arrangement and the reciprocal distance between the tabs 3 is important for optimizing the thermal dispersion. In this sense, a parallelepiped form optimizes the heat dissipation.

Moreover, the parallelepiped form optimizes the modular composition between two or more devices and allows the scalability. In brief, both the development of the sink in the modular sense and the need of maintaining the tabs parallel between them, exclude forms different from those prospected, for example the cylindrical forms.

The central body 2, as also shown in figure 2, is full and includes a wire conduit 8 and a space 7 for holding light emitting devices, such as LED, or light absorbing devices. The space 7, arranged in correspondence of the inferior surface 2", can therefore be closed easily with a transparent covering, for example made of glass, with protective and optical functions, which is applied in the seat 9.

As shown in figure 2 and in the top view of figure 1, the wire conduit 8 actually forms a channel that runs internally through all or part of the central body 2 of the sink. In this way, on one part the device results connectable to an electrical feeder in such a way that the wire is capable of feeding the LED connected in their own appropriate space 7. Contextually, the device results connectable on the opposite part, or eventually on both parts, to further devices 1 in such a way as to realize a modular composition from the different functionalities and geometrical variants.

The connection takes place by the head from the parts lacking tabs and, unlike US2010259927, for example, this allows a high flexibility. Moreover, a passage of wires thus made is ideal precisely to favour the modularity between the parts. As always shown in figure 1, according to the invention, the sink is therefore provided with a plurality of vertical tabs 3 which are appropriately distanced between them and that have the function of dissipate the heat produced by the LED (or other said device) during their functioning without the help of a forced ventilation.

In order to optimize the thermal dispersion in air, the tabs must maintain a reciprocal spacing variable between 9mm and 11mm and preferably of 10mm. The optimal distance of 10mm, together with the parallel arrangement of the tabs, in fact guarantees an optimal passage of air for cooling. A spacing below said range, and in particular an inferior spacing to said 10mm, causes a progressive mutual radiation between the tabs themselves and an increase in friction in the passage of air. The whole, in summary, translates in a progressive reduction of the heat dissipation by radiation and by the convective effect of the passage of air. On the other hand, a spacing superior to 11mm, or preferably superior to said 10mm, implies necessarily a reduction of the number of tabs, at equal length of the device, and therefore a reduction of the thermal dissipation surface.

The thickness "s" of the tabs is generally comprised within a range between 2mm and 3,5mm. In order to maintain a good mechanical toughness and thermal conductivity, without excessive restriction of the channels, the thickness is selected in the order of the 2 mm.

The sink of figure 1 can generally have length **(1)** of about 101mm and width **(L)** of about 100mm for a height **(h)** of about 50mm.

If it is necessary to dissipate greater thermal power in a single sink (1), its height can usefully develop up to 80 mm, as also the length (1') of the tabs. Once these measures are exceeded, it becomes clear that there is a progressive loss of efficiency. The optimal of the thermal dispersion is obtained with a height (h) comprised between about 50mm and 60mm.

The figures to follow, 3, 4 and 5, show some examples of composition of modular dissipators.

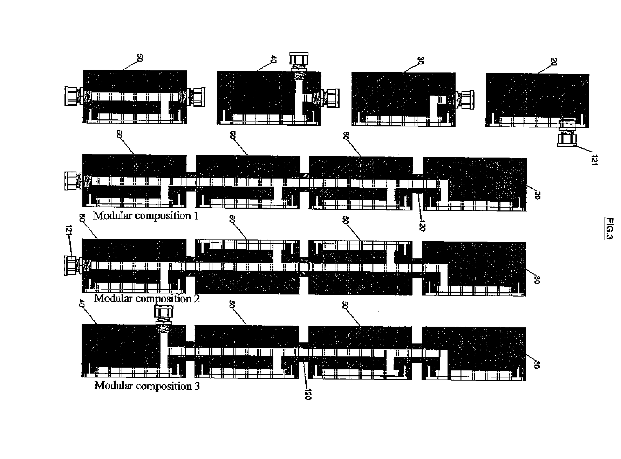

In particular, figure 3 shows how each device is provided with connection means 120 capable of being connected between them and according to different geometries two or more devices. Said connection means 120 serve also to connect one of the modules with a feeder. Always as shown in figure 3, a simple solution of such connection means 120 can foresee a double-screw joint 120 (of appropriate length) that is screwed to a corresponding thread of a second module. The joint ends in correspondence of the wire conduit.

As shown in figure 2, the wire conduit 8 is completed by the transversal conduit that ends precisely in the attachment seat 7 where the led are arranged to bring the electrical feeding to it. The eventual transparent cover in the seat 9 protects all the electrical part.

Figure 3, just as a way of example, shows a series of dissipating devices (20, 30, 40, 50) which are identical between them except that, in the specific example, in the position of the attachments and of the wire conduit in such a way that they can connect between them, constituting different forms. These compositions can eventually connect to a body containing the feeder by using the attachment means 120 for the passage of the wires and ending with cable glands 121.

Figure 3 therefore shows possible combinations obtainable by selecting some modules. For example, a first possible modular composition 1 is indicated that uses three modules 50 connected between them in series and a module 30. The modular composition 1 is advantageous also because it can be used inverted in such a way as to protect the LED space from water infiltrations in the external applications.

The modular composition 2 uses the same three modules 50 of the composition 1 but two of these (the central ones) are inverted. The third modular composition shows a solution wherein two central modules 50 are connected to a module 40 on one end and to a module 30 on the opposite end.

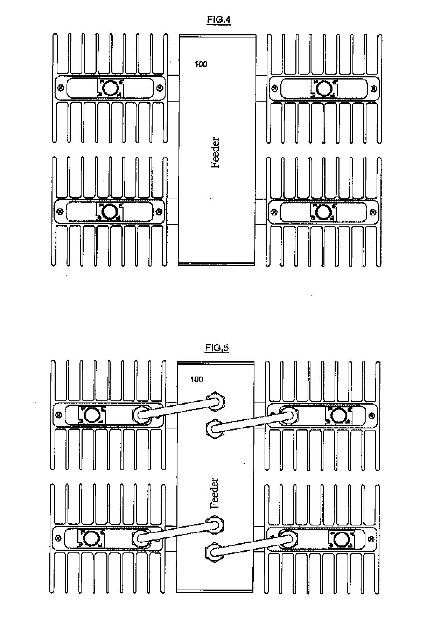

Figure 4 shows the case of four devices which are all connected, with a different geometry, to a single feeder 100 placed at the centre.

Figure 5 shows a similar example wherein external electrical connection (wires) are foreseen.

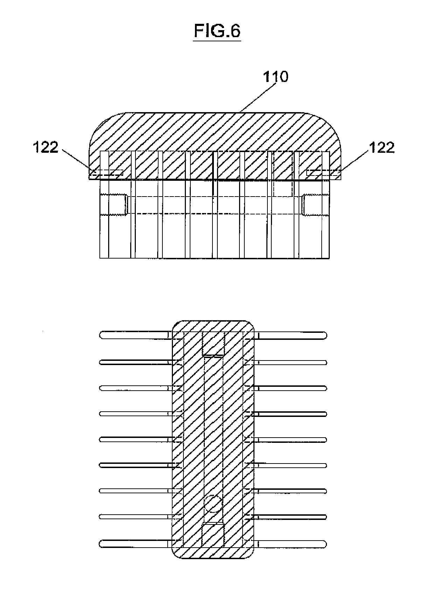

Figure 6 shows a further solution wherein the cover for the LED has the shape of a dome 110, fixed laterally by means of screws 122.

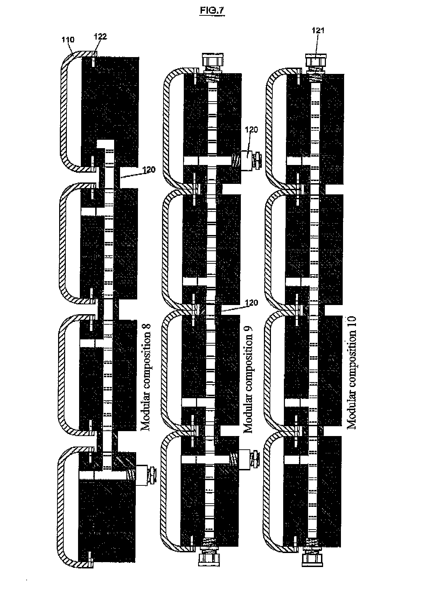

Subsequent figure 7 shows always some modular compositions of devices provided with said dome.

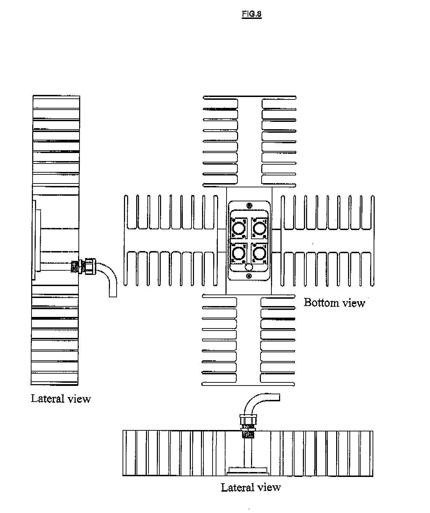

Figure 8 shows a further modular solution, for example in the form of a star.

Although the present figures and the descriptions refer in detail to the LED, it is clear that the same invention is equally usable, also for light absorbers, such as concentrated light photovoltaic cells, by simply adapting the width of the central body 2 and shaping appropriately the receiving seats and the attachment means (7, 8, 9). To that aim, with the term semiconductor light emitters and light absorbers, it is intended the assembly of devices comprising said semiconductor light emitters (LED and LASER LED), concentrated photovoltaic cells, Seebeck effect devices or thermal micromotors.

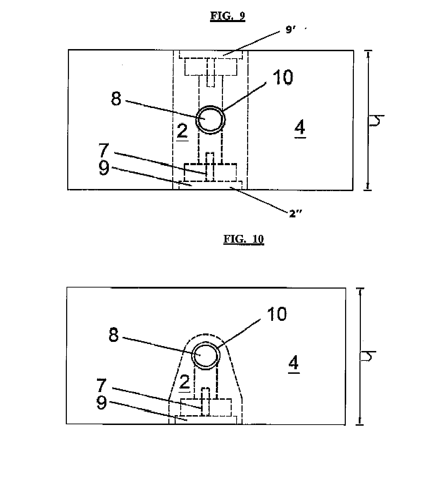

To that aim, for example, figure 9 shows a further solution that is particularly advantageous.

In this case, the inferior surface 2", like in the preceding solution, foresees the application of the LED. The fact of having realized a sink with a central body 2 from which branch off the tabs radially only from the lateral surfaces, allows to use both the superior surfaces 2' and inferior 2" surfaces of the central body. In accordance with figure 9, therefore, a space 9' is shown that allows the holding of light absorbers to produce energy, for example a concentrated photovoltaic device. In this way, the device of figure 9 serves a double function contextually. The sink 1, during the day, dissipates the heat produced by the light absorbing device arranged in the superior seat and during the night dissipates the heat produced by the LED arranged in the inferior seat. With a dotted line it is therefore shown a transversal conduit that from the space 9' intercepts the conduit 8 for the passage of wires.

The figure 10 shows a further constructive variant wherein the central body 2, from which the tabs of height h branch off, has a height inferior to the tabs themselves to favour even more the flow of the circulating air.

## Claims

1. A heat sink **(1)** for semiconductor light emitters or for light absorbers and comprising:
- A central portion **(2)** provided with attachment means **(7, 8, 9)** on which it is possible to fix the light emitter or the absorber;
- a plurality of tabs **(3)** that branches off from the central body in such a way that the sink results of a parallelepiped shape, said tabs being distanced between them so as to form a plurality of channels for the circulation of air and arranged parallel between them;
**characterized in that** a reciprocal distance is foreseen between a tab and the subsequent one comprised within a range variable between 9 mm and 11 mm in such a way as to optimize the passage of air for cooling.

2. A heat sink **(1),** according to claim 1, wherein the tabs are placed at a reciprocal distance of 10 mm.

3. A heat sink **(1),** according to one or more of the preceding claims, wherein the sink is of aluminium or aluminium alloy.

4. A heat sink **(1),** according to one or more of the preceding claims, wherein the central body (2) has a parallelepiped shape and comprises a superior flat surface (2'), an inferior flat surface (2") provided with said attachment means (7, 9), two lateral surfaces (2"'), a front surface (4') and a back surface (5'), the tabs (3) branching off radially only from the two lateral surfaces (2"').

5. A heat sink **(1),** according to one or more of the preceding claims, wherein the central body (2) foresees a conduit (8) for the passage of the wires, the conduit ends in at least one or both of the front faces (4') and back faces (5') of the central body (2) .

6. A heat sink **(1),** according to claim 5, wherein the conduit for the wires runs longitudinally along at least one part of the central body (2).

7. A heat sink (**1**), according to claim 5 or 6, wherein the wire conduit intercepts a vertical stretch that ends in correspondence of the attachment means (7, 9).

8. A heat sink (**1**), according to one or more of the preceding claims, wherein connection means **(120)** are foreseen so it is possible to connect in a modular manner between them two or more sinks **(1),** said connection means being arranged in correspondence of the point where the wire conduit (8) ends in the front face (4) and/or the back face (5).

9. A heat sink **(1),** according to one or more of the preceding claims, wherein a covering **(110)** is foreseen with protection and optical functions, arranged above the attachment means **(7, 9)** to cover the light emitters to semiconductors or the light absorbers.

10. A heat sink **(1),** according to one or more of the preceding claims, wherein said attachment means **(7, 9)** comprise a space **(7)** for lodging the light emitters or the light absorbers.

11. A heat sink **(1),** according to one or more of the preceding claims, wherein a feeding body **(100)** is foreseen, connected to one or more heat sinks through said connection means **(120).**

12. A heat sink (**1**), according to one or more of the preceding claims, wherein the height (h) of the tab (3) can reach 80mm, and is preferably of 60mm.

13. A heat sink **(1),** according to one or more of the preceding claims, wherein the superior surface (2') foresees second attachment means (9') so it is possible to arrange a light absorber opposite to the light emitters.

14. A modular apparatus **characterized in that** it comprises one or more of said heat sinks (1) according to one or more of the preceding claims from 1 t 13, which are connected between them in a separable and reassembled manner.

15. A modular apparatus, according to claim 14, wherein connection means **(120)** are foreseen to connect in a modular manner a sink to another one.
